Europäisches Patentamt

European Patent Office

Office européen des brevets

(11) Publication number: **0 234 269**
**A2**

# (12) EUROPEAN PATENT APPLICATION

(21) Application number: 87100766.2

(22) Date of filing: 21.01.87

(51) Int. Cl.4: **H01L 29/06** , **H01L 29/78** , **H01L 27/08** , **H01L 21/82**

The title of the invention has been amended (Guidelines for Examination in the EPO, A-III, 7.3).

(30) Priority: 24.01.86 IT 1917486

(43) Date of publication of application:
**02.09.87 Bulletin 87/36**

(84) Designated Contracting States:
**DE FR GB NL SE**

(71) Applicant: **SGS MICROELETTRONICA S.p.A.**
**Stradale Primosole 50**
**I-95121 Catania(IT)**

(72) Inventor: **Contiero, Claudio**
**Via Giovanni XXIII 5**
**I-20090 Buccinasco (Milan)(IT)**
Inventor: **Galbiati, Paola**
**Via Ramazzotti 24**
**I-20052 Monza (Milan)(IT)**
Inventor: **Andreini, Antonio**
**Via Capecelatro 38**
**I-20148 Milan(IT)**

(74) Representative: **Modiano, Guido et al**
**MODIANO, JOSIF, PISANTY & STAUB**
**Modiano & Associati Via Meravigli, 16**
**I-20123 Milan(IT)**

(54) High voltage semiconductor integrated circuit.

(57) This semiconductor integrated circuit has high thickness oxide layers such as to ensure the provision of efficient and reliable high-voltage devices, simultaneously eliminating sharp differences of level on the surface of the circuit in the high density signal processing part. The circuit comprises a semiconductor body defined by a plurality of superimposed layers (40-49) having conductivity of opposite types and at least one oxide insulating layer (50-53) extending over a major surface of the semiconductor body at preset portions thereof, the insulating oxide layer, close to the outer delimiting edges of the preset portions, having a decreasing thickness so as to form peripheral regions (55) sloping towards the semiconductor body major surfaces.

FIG. 4

## SEMICONDUCTOR INTEGRATED CIRCUIT, PARTICULARLY OF THE TYPE COMPRISING HIGH-VOLTAGE DEVICES AND HIGH DENSITY SIGNAL PROCESSING DEVICES

The present invention relates to a semiconductor integrated circuit, particularly of the type comprising high-voltage devices and high density signal processing devices.

As is known, technological evolution and compacting requirements require integration of an ever-increasing number of functions in the same semiconductor integrated circuit. In particular, the need is increasingly felt to integrate in a single circuit components capable of withstanding high voltage levels and, simultaneously, complex signal processing parts.

Consequently, the need is felt of structures and processes which render simultaneous and compatible the production of efficient high-voltage devices together with high-integration-density signal processing structures.

However, in practice, difficulties arise due to the fact that the requirements of the two cases are scarcely compatible. Indeed, in the case of high voltage values, the structures commonly employed (see F.CONTI-M.CONTI: "Surface breakdown in silicon planar diodes equipped with field plate, Solid State Electronics", 1972, vol. 15, pages 93-105) to increase the voltage resistance require high thicknesses dielectric materials (e.g. $SiO_2$), while in the case of high density integration of signal processing components it is necessary to avoid the production of high and sharp level changes (steps) on the surface of the device, since in this case it would be difficult to achieve interconnections (e.g., metalizations) which are small and free from interruptions or surface discontinuities.

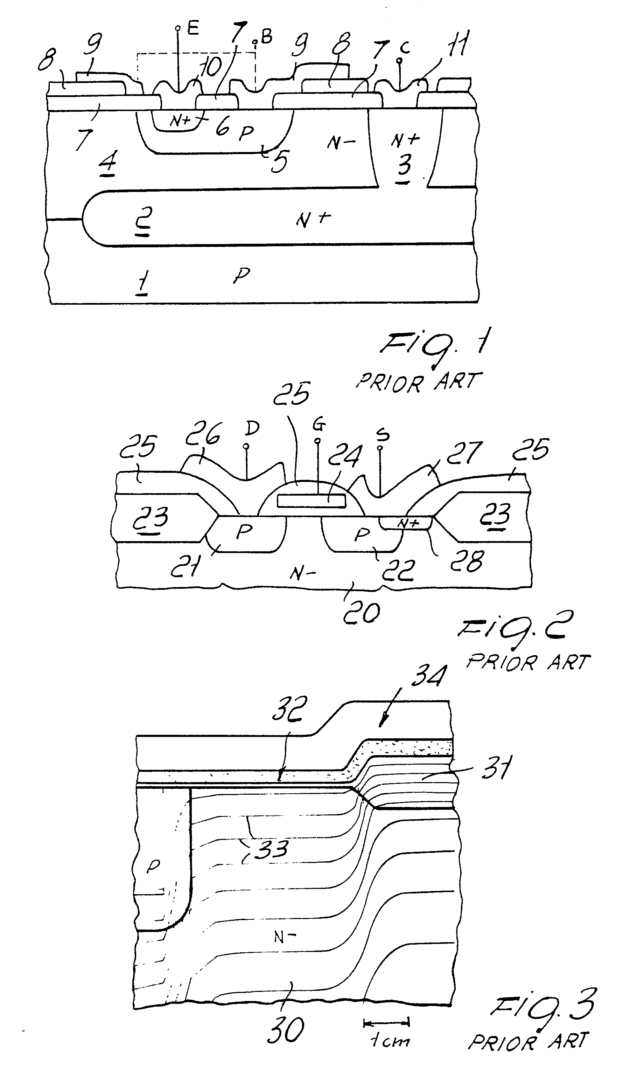

A known attempt to solve this problem in the case of high voltage level devices consists of providing a structure having two layers of silicon oxide with different extensions. An example of an embodiment for an NPN bipolar high voltage transistor is illustrated in Fig. 1. In particular, according to the prior art, the first layer is composed of thermal oxide which constitutes the field oxide, while the second layer is composed of vapor-phase deposited oxide, and the two layers are surmounted by a field plate which allows to increase the breakdown voltage. Such structures, known as "biplanar" (registered trademark), have yielded good results in the case of high-voltage devices, but they do not allow to integrate simultaneously and reliably high density signal components due to the persistent presence of sharp discontinuities of the surface due to the sharp differences in the height of the oxide.

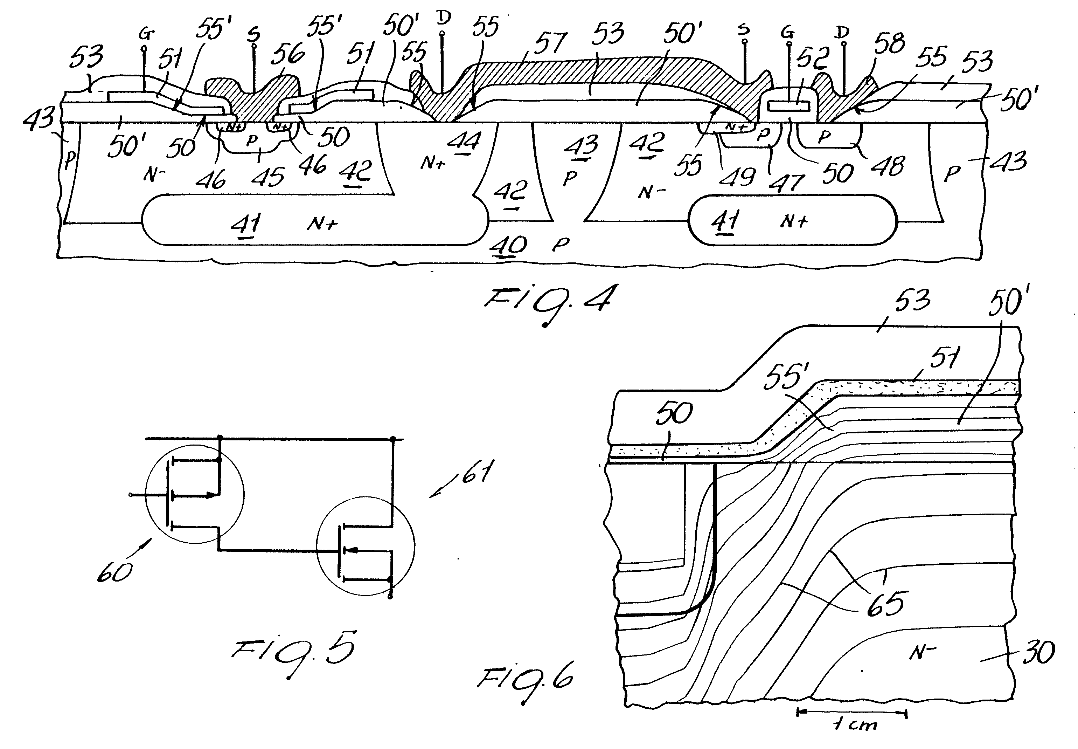

A known solution, which allows to obtain low and gradual surface differences in height, is known as "planox" and comprises a layer of thermal oxide along and in part within the outer surface of the semiconductor, surmounted by another layer of vapor phase deposited oxide (CVD). An example of embodiment of a signal P-channel MOS transistor is illustrated in Fig. 2. This solution, though it allows to have low and gradual surface level changes, and therefore reduces the risk of surface interruptions or fractures in the outer interconnections (metalizations), is however scarcely suitable for the production of high-voltage devices due to the aggregation of the electric field lines at the beak end portion (oblique faces of the thermal oxide layer) which causes a reduction in the breakdown voltage with respect to the solution indicated in Fig. 1.

Given this situation, the aim at the base of the present invention is to provide methods and structures for the production of whatever integrated circuit, in particular for the simultaneous production of high-voltage devices and high-density signal processing devices, which, without the addition of supplementary process steps, is not affected by the prior art disadvantages.

Within the scope of this aim, a particular object of the present invention is to provide an integrated circuit which simultaneously presents oxide thicknesses such as to ensure the reliable operation of the high-voltage components and with such an arrangement as to eliminate the presence of steps or high level changes in the oxide and thereby reduce the chance of surface interruptions or discontinuities of the interconnections (e.g., metalizations).

Still another object of the present invention is to provide an integrated circuit without high equipotential field line density and therefore high applied electric field surfaces, so as to ensure high breakdown voltages.

Not least object of the present invention is to provide an integrated circuit which can be manufactured using the machines currently employed in the electronics industry to manufacture electronic integrated circuits, and which therefore has manufacturing costs which are comparable with those of known devices.

The above described aim, the objects mentioned and others which will become apparent hereinafter are achieved by a semiconductor integrated circuit, in particular of the type comprising high-voltage devices and high density signal processing devices, comprising a semiconductor body defined by a plurality of superimposed layers with opposite conductivity types and at least one insulating oxide layer, extending over a major surface of said semiconductor body at preset portions thereof, characterized in that said at least one insulating oxide layer, proximate to the peripheral delimiting edges of said preset portions, has a decreasing thickness so as to form peripheral regions which are sloping towards said major surface.

Further characteristics and advantages will become apparent from the description of a preferred, and not exclusive, embodiment, illustrated only by way of non limitative example in the accompanying drawings, where:

Figs. 1 and 2 are two transverse cross section views through two prior integrated circuits;

Fig. 3 is a detailed cross section view of a device produced according to the "planox" method illustrating the pattern of the equipotential field lines when said device is biased by voltage;

Fig. 4 is a cross section view through a semiconductor integrated circuit according to an embodiment of the present invention;

Fig. 5 is an equivalent electric diagram of the circuit of Fig. 4; and

Fig. 6 is a detailed cross section view of the semiconductor integrated circuit of Fig.4 illustrating the pattern of the equipotential lines when the device is biased by voltage.

With reference to Fig. 1, it illustrates a high voltage NPN bipolar transistor, provided according to the known "biplanar" structure. In detail, the known circuit comprises a substrate 1 with P polarity, a buried layer 2 with N⁺ polarity connected to the region 3, also of N⁺ polarity, and constituting the collector region. Above the buried layer 2, the epitaxial layer 4 with N⁻ polarity is arranged, in which layer the P base regions 5 and the N⁺ emitter region 6 are provided. The upper major surface of the semiconductor body formed by the substrate 1 and by the epitaxial layer 4 is covered by two oxide layers which extend selectively, and comprise a thermal oxide layer 7 which acts as field oxide and which stops at the base, emitter and collector contact areas, and a second layer 8 of vapor phase deposited oxide having a smaller surface extension than the layer 7 so as to leave an edge portion of the latter uncovered. The structure is comp. 'ed by the field plate 9 which also constitutes the base metalization, the emitter metalization 10 and the collector metalization 11. As can be seen from the figure, such a solution divides in two parts the oxide layer thickness, yet it still has sharp and steep discontinuities on the oxide layer which, in the case of manufacture of high density signal processing devices, may lead to discontinuities in the interconnections.

Fig. 2 illustrates another known solution, and in particular it refers to a signal P-channel MOS transistor, provided with a "planox" structure. As can be seen in the figure (in which the substrate and the buried layer have been omitted, and of which only the epitaxial layer 20 with N⁻ polarity and the drain 21 and source 22, P regions, as well as the N⁺ region 28 for the body contact, have been illustrated), this structure comprises an oxide layer 23 provided in the main upper surface of the device, with a portion extending inside the epitaxial layer and a portion protruding outside thereof. This thermal oxide layer 23, which has a pointed region (beak) at its peripheral delimiting edge, is surmounted by another layer of vapor-phase deposited oxide 25. The structure is completed by the gate region 24 of polycrystalline silicon with N⁺ polarity and the metalizations 26 and 27 respectively taken to the drain and source contacts. The gate contact has also been symbolized at G in the figure. This known solution, which is very advantageous for the production of signal processing devices since it allows to lower and soften the surface level changes, cannot be reliably used to produce high-voltage devices, since in this case there would be an increase in the electric field at the edge of the thermal oxide 23 (beak) and a consequent reduction in breakdown voltage. This phenomenon is illustrated in the schematic drawing of Fig. 3, in which a possible D-MOS has been illustrated, which is provided according to the "planox" method, and comprises a substrate 30, a thermal oxide layer 31, a polycrystalline silicon layer 32 with N⁺ polarity which acts as a field plate and a vapor-phase deposited oxide layer 34. As can be seen, in the lower sloping portion of the oxide layer 31, the equipotential lines (schematically indicated at 33 in the figure) would aggregate with high density, causing a local increase in the electric field. This causes the structure illustrated to be subject to early breakdown phenomena with respect to the similar devices produced with the field plate solution of Fig.1, rendering unreliable the integrated circuit manufactured thereby.

Fig. 4, instead, illustrates a cross section of a circuit which comprises, to the left, an N-channel D-MOS high voltage transistor and, to the right, a P-channel MOS signal transistor. In detail and - schematically, the integrated circuit produced according to the present invention comprises a substrate 40 with P polarity and an epitaxial layer 42 with N⁻ polarity, inside which the buried layers 41 of the N⁺ type, the vertical insulation P regions 43 and the N⁺ drain region 44 belonging to the high voltage D-MOS are provided. This transistor is completed by the P regions 45, the N⁺ regions 46, the gate oxide layer 50, the field oxide layer 50', the gate polycrystalline. silicon region 51 and the upper vapor phase deposited oxide layer 53. The source 56 drain 57 metalizations leading to the related contacts S and D are furthermore provided, while in the figure the gate contact G has only been schematically indicated. In turn, the P-channel signal MOS transistor comprises the P regions 47 and 48, respectively source and drain, the gate oxide layers 50, the field oxide 50', and the upper vapor phase deposited oxide 53 as well as the polycrystalline silicon gate region 52. The circuit is completed by the drain metalization 58 which leads to the related contact D and by the source metalization 57 produced in common with the drain one of the high-voltage D-MOS device. The gate contact has only been schematically inidcated at G in the figure.

As far as the succession of the layers described is concerned, the device illustrated exactly matches the known devices. The peculiarity of the invention lies, instead, in the use of sloping steps (indicated with the reference numerals 55 and 55') proximate to the peripheral delimiting edge of the field oxide regions deposited on the surface of the semiconductor body. In detail, as can be seen from the figure, the sloping steps 55 constitute the peripheral delimiting edges of the oxide regions related to the signal MOS, while the sloping steps 55' at the gate oxide of the high voltage D-MOS are arranged slightly further away from the outer edge. This solution allows to provide efficient biplanar high voltage structures with an oxide thickness which is sufficient to withstand the high voltages applied, and simultaneously to provide small interconnections on the high-integration-density signal processing part, without problems related to interruptions or discontinuities. The equivalent electric circuit of the device of Fig. 4 is illustrated in Fig. 5 and comprises a signal P-channel MOS 60 and an N-channel high voltage D-MOS 61 connected as illustrated in the figure.

Fig. 6, similar to Fig. 3 to point out the differences between the two structures, but in a different scale, illustrates the pattern of the equipotential lines at the epitaxial layer 30 -gate oxide layer 50 transition of the D-MOS of figs. 4 and 5, embodied according to the present invention: a sloping step 55' connects the gate oxide 50 to the field oxide 50' forming a biplanar structure.

As can be seen in the figure, in this case the equipotential lines 65 are much further spaced apart, thus allowing to have a higher breakdown voltage with a lower epitaxial resistivity, and thus providing more efficient high voltage structures.

The embodiment of the sloping step according to the present invention can occur according to various per se known methods (see -J. Götzlich and H.Ryssel, J. Electrochem. Soc. Vol. 128, No 3 March 1981 -J.C. North, T.E. McGahan, D.W. Rice and A.C. Adams, IEEE Tran. El Devices, Vol. ED-25, No. 7 July 1978). As an example, it is possible to perform a surface damaging of a yet masked oxide layer by implant (e.g. of arsenic) so that, after the realization of the protection mask, by performing chemical etching of the unprotected regions, also the neighboring regions damaged by the implanting are partially removed, with the consequent production of the sloping step. The increase of the speed of etching of the surface oxide layer can otherwise be performed by depositing a thin layer of vapox, which has a greater etching speed with respect to thermal oxide and therefore behaves approximately in the same manner as the surface damaging by implant. After providing the sloping step, the device is completed according to the known methods; in particular, in the high voltage region it is possible to provide biplanar structures by using as a field plate the polycrystalline silicon gate with the slightly smaller field oxide layer.

As can be seen from the above description, the invention fully achieves the intended aims. Indeed, a structure has been provided having on one hand the high oxide thicknesses necessary for a reliable operation of high voltage devices, and on the other hand eliminating sharp level changes in the oxide layer as far as the signal processing region is concerned, practically eliminating the risk of the forming of fractures and discontinuities on the layers deposited thereover, thus ensuring the production of compact and reliable signal processing devices.

Furthermore the proposed structure does not have a reduction in the breakdown voltage of the high voltage part by virtue of the possibility of forming a biplanar region with a field plate as in Fig. 6.

The invention thus conceived is susceptible to numerous modifications and variations, all of which are within the scope of the inventive concept. In particular, the fact is stressed that the circuit illustrated is only an example, and in particular any circuit provided so as to have sloping steps, especially the circuits comprising a high voltage part and a signal processing, is within the scope of the invention.

Moreover, all the details may be replaced with other technically equivalent ones.

## Claims

1. Semiconductor integrated circuit, in particular of the type comprising high voltage devices and high density signal processing devices, comprising a semiconductor body (40-49) defined by a plurality of superimposed layers with opposite conductivities and at least one insulating oxide layer (50-53), extending over a major surface of said semiconductor body at preset regions thereof, characterized in that said at least one insulating oxide layer - (50-53), close to outer delimiting edges of said preset portions, has decreasing thickness portions - (55,55') thereby forming sloping peripheral regions which are sloping towards said major surface.

2. Integrated circuit according to claim 1, characterized in that said sloping peripheral regions have a thickness decreasing with continuity.

3. Integrated circuit according to claim 1 or 2, characterized in that said sloping peripheral regions have a thickness decreasing approximately linearly.

4. Integrated circuit according to one or more of the preceding claims, characterized in that it comprises two superimposed oxide layers (50,50' ,53) defining said sloping peripheral regions, said two superimposed oxide layers having offset outer delimiting edges defining a so-called biplanar structure.

5. Integrated circuit according to one or more of the preceding claims, characterized in that said sloping peripheral regions define "sloping steps".

6. Method for manufacturing an integrated circuit, in particular of the type comprising high voltage devices and high density signal processing devices, comprising: manufacture of a semiconductor body having a plurality of superimposed layers and deposition of a first oxide layer over a major surface of said semiconductor body, characterized in that above or in said first oxide layer a thin oxide layer is formed, having a lower resistance to etching than said first oxide layer, a protection mask is deposited and a chemical etching phase is selectively performed on portions of said first and thin oxide layers to thereby remove portions of said first and thin oxide layers not covered by said mask and, partially, peripheral portions of protected portions of said thin oxide layers, so as to form sloping peripheral regions with decreasing thickness.

Fig. 1
PRIOR ART

Fig. 2
PRIOR ART

Fig. 3
PRIOR ART

FIG. 4

FIG. 5

FIG. 6

0 234 269